# EUROPEAN PATENT APPLICATION

(11) **EP 4 773 511 A1**
(43) Date of publication of application: **08.07.2026**
(21) Application number: 24858741.2
(22) Date of filing: 30.08.2024
(51) Int. Cl.: H03K 19/0175

(54) **PIN-MULTIPLEXED TRIMMING CIRCUIT, TRIMMING CHIP, AND TRIMMING METHOD FOR CHIP**

(30) Priority: 30.08.2023 CN 202311109440
(71) Applicant: Beijing GL-Microelectronics Technology Co. Ltd., Beijing 100190 (CN)
(72) Inventor: CHI, Ming, Beijing 100190 (CN); YANG, Yu, Beijing 100190 (CN)
(74) Representative: CH Kilger Anwaltspartnerschaft mbB
(86) International application number: PCT/CN2024/115919
(87) International publication number: WO 2025/045212

(57) **Abstract**

Provided are a pin-multiplexed trimming circuit, a trimming chip, and a trimming method for a chip. The pin-multiplexed trimming circuit comprises a first superposition circuit and a trimming chip; the trimming chip comprises a separation circuit, a control circuit, and an in-chip trimming circuit; the first superposition circuit is electrically connected to the separation circuit by means of a power input pin of the trimming chip; the first superposition circuit receives a power supply signal and superposes the power supply signal with a first data signal sent by a controller to obtain a first fused signal; the separation circuit separates the first fused signal to obtain a second data signal and the power supply signal; the power supply signal supplies power to the in-chip trimming circuit, the separation circuit, and the control circuit; the control circuit decodes the second data signal to obtain a third data signal and sends the third data signal to the in-chip trimming circuit.

## Description

### RELATED APPLICATION

The present disclosure claims priority of Chinese Patent Application No.202311109440.6, titled "pin-multiplexed trimming circuit and trimming method", and filed on August 30, 2023, which is hereby incorporated by reference in its entirety.

### TECHNICAL FIELD

The present disclosure relates to the technical field of integrated circuits, and particularly to a pin-multiplexed trimming circuit, a trimming chip, and a chip trimming method.

### BACKGROUND

For the design of analog integrated circuits such as a high-precision reference, an operational amplifier, and an analog-to-digital (AD) converter, the precision requirements for the circuit parameters are extremely high. Therefore, trimming is generally performed on a chip after package, and it is necessary to read back a trimming result. The conventional approaches utilize data pins in the chip to write and read the data of fuse trimming. However, the use of the data pin for the fuse trimming causes the data pin to be connected to both a functional circuit and a trimming circuit in the trimming chip simultaneously, which potentially causing instability of the chip in use.

### SUMMARY

In view of the above problem in the prior art, an objective of the present disclosure is to provide a pin-multiplexed trimming circuit, a trimming chip and a chip trimming method, so as to address the chip instability caused by the use of data pins in the prior art.

In order to solve the above technical problem, the specific technical solutions of the present disclosure are as follows.

In an aspect, the present disclosure provides a pin-multiplexed trimming circuit, including: a first superimposing circuit and a trimming chip, wherein the trimming chip includes a separation circuit, a control circuit and an in-chip trimming circuit, and the first superimposing circuit is electrically connected to the separation circuit through a power input pin of the trimming chip;
the first superimposing circuit is configured to receive a power supply signal and a first data signal sent by a controller, and superimpose the power supply signal with the first data signal to obtain a first fused signal;
the separation circuit is configured to separate the first fused signal to obtain a second data signal and the power supply signal; the power supply signal is configured to supply power to the in-chip trimming circuit, the separation circuit, and the control circuit; and
the control circuit is configured to decode the second data signal to obtain a third data signal, and send the third data signal to the in-chip trimming circuit in the trimming chip.

As an embodiment of the present disclosure, the pin-multiplexed trimming circuit further includes a state detection circuit and a second superimposing circuit; the state detection circuit is electrically connected to the separation circuit and the second superimposing circuit, respectively;
the state detection circuit is configured to detect a flag bit of the second data signal, disable the second superimposing circuit when the flag bit is a first type of flag bit, and enable the second superimposing circuit when the flag bit is a second type of flag bit;
the second superimposing circuit is configured to receive read-back data of the in-chip trimming circuit, superimpose the read-back data with the power supply signal to obtain a second fused signal, and send the second fused signal to the controller through the power input pin.

As an embodiment of the present disclosure, the first superimposing circuit includes a first inverter, an MN1, a resistor R1 and a resistor R2;
an input end of the first inverter receives the first data signal sent by the controller, and an output end of the first inverter is connected to a gate of the MN1;
a source of the MN1 is grounded through the resistor R2; and
a drain of the MN1 receives the power supply signal through the resistor R1, and the drain of the MN1 is connected to the power input pin.

As an embodiment of the present disclosure, the first superimposing circuit includes a switch, an oscillating circuit, a resistor R3, a resistor R5, a resistor R6, a resistor R7, a resistor R8, a resistor R9, a first operational amplifier and a third operational amplifier;
the oscillating circuit receives the power supply signal through the switch, and the switch receives the first data signal to be turned on or off; the oscillating circuit is configured to output an oscillating signal when the switch is turned on;
the oscillating signal is sent to a non-inverting input end of the first operational amplifier through the resistor R3;
the resistor R6 and the resistor R7 are connected in series, and the power supply signal is grounded through the resistor R6 and the resistor R7;
a non-inverting input end of the third operational amplifier is disposed at a junction of the resistor R6 and the resistor R7, an inverting input end of the third operational amplifier is connected to an output end of the third operational amplifier, and the resistor R5 is connected in series between the output end of the third operational amplifier and the non-inverting input end of the first operational amplifier;
an output end of the first operational amplifier is grounded through the resistor R8 and the resistor R9, and a junction of the resistor R8 and the resistor R9 is connected to an inverting input end of the first operational amplifier; and
the output end of the first operational amplifier is connected to the power input pin.

As an embodiment of the present disclosure, the separation circuit includes a first comparator;
a non-inverting input end of the first comparator receives the first fused signal, and an inverting input end of the first comparator receives a reference voltage; and
the first comparator compares the first fused signal with the reference voltage; when the first fused signal is greater than the reference voltage, an output end of the first comparator outputs the second data signal at a high level; and when the first fused signal is less than the reference voltage, the output end of the first comparator outputs the second data signal at a low level.

As an embodiment of the present disclosure, the separation circuit includes a second inverter, a second operational amplifier and a second comparator;
a non-inverting input end of the second operational amplifier receives the first fused signal;
an input end of the second inverter receives the first fused signal, and an output end of the second inverter is connected to an inverting input end of the second operational amplifier; and
output ends of the second operational amplifier are connected to input ends of the second comparator, and an output end of the second comparator outputs the second data signal at a different level.

In another aspect, the present disclosure further provides a trimming chip, including: a power input pin, a separation circuit, a control circuit and an in-chip trimming circuit, wherein the power input pin is electrically connected to the separation circuit, and the control circuit is electrically connected to the separation circuit, and the in-chip trimming circuit is electrically connected to the control circuit;
the power input pin is configured to receive a first fused signal, which is formed by superimposing a power supply signal and a first data signal for trimming;
the separation circuit is configured to separate the first fused signal to obtain the power supply signal and a second data signal; the power supply signal is configured to supply power to the in-chip trimming circuit, the separation circuit and the control circuit; and
the control circuit is configured to decode the second data signal to obtain a third data signal and send the third data signal to the in-chip trimming circuit.

As an embodiment of the present disclosure, the trimming chip further includes a state detection circuit and a second superimposing circuit; the state detection circuit is electrically connected to the separation circuit and the second superimposing circuit, respectively, and the second superimposing circuit is electrically connected to the power input pin and the control circuit, respectively;
the state detection circuit is configured to detect a flag bit of the second data signal, disable the second superimposing circuit when the flag bit is a first type of flag bit, and enable the second superimposing circuit when the flag bit is a second type of flag bit; and
the second superimposing circuit is configured to receive read-back data of the in-chip trimming circuit, superimpose the read-back data with the power supply signal to obtain a second fused signal, and output the second fused signal through the power input pin.

As an embodiment of the present disclosure, the in-chip trimming circuit is a fuse trimming circuit.

As an embodiment of the present disclosure, the second superimposing circuit includes a first inverter, an MN1, a resistor R1 and a resistor R2;
an input end of the first inverter receives the read-back data, and an output end of the first inverter is connected to a gate of the MN1;
a source of the MN1 is grounded through the resistor R2; and
a drain of the MN1 receives the power supply signal through the resistor R1, and the drain of the MN1 is connected to the power input pin.

As an embodiment of the present disclosure, the separation circuit includes a first comparator;
a non-inverting input end of the first comparator is electrically connected to the power input pin and configured to receive the first fused signal, an inverting input end of the first comparator is configured to receive a reference voltage, and an output end of the first comparator is electrically connected to the control circuit;
the first comparator compares the first fused signal with the reference voltage; when the first fused signal is greater than the reference voltage, the output end of the first comparator outputs the second data signal at a high level; and when the first fused signal is less than the reference voltage, the output end of the first comparator outputs the second data signal at a low level.

As an embodiment of the present disclosure, the separation circuit includes a second inverter, a second operational amplifier and a second comparator;
a non-inverting input end of the second operational amplifier is electrically connected to the power input pin and configured to receive the first fused signal;
an input end of the second inverter is electrically connected to the power input pin and configured to receive the first fused signal, and an output end of the second inverter is connected to an inverting input end of the second operational amplifier;
output ends of the second operational amplifier are connected to input ends of the second comparator; and
an output end of the second comparator is electrically connected to the control circuit and configured to output the second data signals at a different level.

As an embodiment of the present disclosure, the second comparator includes an MP3, an MP4, an MP5, an MP6, an MP7, an MP8, an MP9, an MN4, an MN5, an MN6, an MN7, an MN8, an MN9, an MN10, an MN11 and an MN12;
sources of the MP3, the MP4, the MP5, the MP6, the MP7, the MP8 and the MP9 all receive the power supply signal;
sources of the MN8, the MN9, the MN10, the MN11 and the MN12 are all grounded;
a gate of the MP3 is short-circuited with a drain thereof, and the gate of the MP3 is connected to a gate of the MP4;
a drain of the MP4 is connected to a drain of the MP5, a gate of the MP5 is short-circuited with a drain thereof, and the gate of the MP5 is connected to a gate of the MP6 and a gate of the MP9;
a drain of the MP7 and a gate of the MP7 are connected to a gate of the MP8, respectively;
a drain of the MP3 is connected to a drain of the MN4 and a drain of the MN5, respectively, and the drain of the MP5 is connected to a drain of the MN6 and a drain of the MN7, respectively;
the drain of the MP6 and the drain of the MP7 are connected to a drain of the MN10, respectively, a drain of the MP8 is connected to a drain of the MN11, and a drain of the MP9 is connected to a drain of the MN12;
a gate of the MN4 and a gate of the MN7 are both connected to a non-inverting input end of the second comparator, and a gate of the MN5 and a gate of the MN6 are both connected to an inverting input end of the second comparator;
a source of the MN4 and a source of the MN6 are both connected to a drain of the MN8, and a gate of the MN8 receives a first bias voltage BIA1;
a source of the MN5 and a source of the MN7 are both connected to a drain of the MN9, and a gate of the MN9 receives a second bias voltage BIA2;
a gate of the MN10 receives the second bias voltage BIA2;
a gate of the MN11 is connected to a gate of the MN12, and the gate of the MN11 is connected to a drain thereof; and
the drain of the MP9 outputs the second data signal.

As an embodiment of the present disclosure, the trimming chip further includes a logic control circuit;
the logic control circuit is configured to adjust the state of the trimming chip according to the first fused signal; when the first fused signal includes the first data signal, enable the separation circuit, the control circuit and the in-chip trimming circuit; and
when the first fused signal does not include the first data signal, enable a functional circuit in the trimming chip.

As an embodiment of the present disclosure, the trimming chip further includes a logic control circuit;
the logic control circuit is configured to adjust the state of the trimming chip according to the first fused signal; when the first fused signal includes the first data signal, enable the separation circuit, the second superimposing circuit, the state detection circuit, the control circuit and the in-chip trimming circuit; and
when the first fused signal does not include the first data signal, enable a functional circuit in the trimming chip.

In still another aspect, the present disclosure provides a chip trimming method, including:
superimposing a first data signal for trimming with a power supply signal to obtain a first fused signal;
inputting the first fused signal to a chip through a power input pin of the chip;
separating the first fused signal to obtain a second data signal and the power supply signal; and
decoding the second data signal to obtain a third data signal for trimming the chip.

As an embodiment of the present disclosure, the method further includes:
superimposing read-back data signal, which indicates a trimming unit of the chip, with the power supply signal to obtain a second fused signal; and
outputting the second fused signal to the outside of the chip through the power input pin of the chip.

By adopting the above technical solutions, the power supply signal is superimposed with the first data signal by the first superimposing circuit to obtain the first fused signal, which is sent to the interior of the trimming chip through the power input pin of the trimming chip, so that the separation circuit in the trimming chip can separate the first fused signal to obtain the second data signal. The control circuit in the trimming chip decodes the second data signal to obtain the third data signal, and sends the third data signal to the in-chip trimming circuit so that the in-chip trimming circuit can perform trimming.

In order that the above and other objectives, features and advantages of the present disclosure can be more readily understood, preferred embodiments of the present disclosure will be described in detail below with reference to the drawings.

### BRIEF DESCRIPTION OF DRAWINGS

In order to more clearly explain the technical solutions in the embodiments of the present disclosure or in the prior art, the drawings to be used in the description of the embodiments or the prior art will be briefly introduced as follows. Obviously, the drawings concerned in the following description only illustrate some embodiments of the present disclosure, and those of ordinary skill in the art can obtain other drawings from these drawings without paying any creative labor.
FIG. 1 illustrates a schematic diagram of a pin-multiplexed trimming circuit according to an embodiment of the present disclosure;
FIG. 2 illustrates a first schematic diagram of a first superimposing circuit according to an embodiment of the present disclosure;
FIG. 3 illustrates a second schematic diagram of a first superimposing circuit according to an embodiment of the present disclosure;
FIG. 4 illustrates a first schematic diagram of an oscillating circuit according to an embodiment of the present disclosure;
FIG. 5 illustrates a second schematic diagram of an oscillating circuit according to an embodiment of the present disclosure;
FIG. 6 illustrates a first schematic diagram of a separation circuit according to an embodiment of the present disclosure;
FIG. 7 illustrates a second schematic diagram of a separation circuit according to an embodiment of the present disclosure;
FIG. 8 illustrates a schematic diagram of a second comparator according to an embodiment of the present disclosure;
FIG. 9 illustrates a schematic diagram of a trimming unit in a fuse trimming circuit according to an embodiment of the present disclosure;
FIG. 10 illustrates a schematic diagram of a trimming circuit with a second superimposing circuit according to an embodiment of the present disclosure;
FIG. 11 illustrates a schematic diagram of a trimming circuit with a logic control circuit according to an embodiment of the present disclosure;
FIG. 12 illustrates a schematic diagram of steps of a chip trimming method according to an embodiment of the present disclosure; and
FIG. 13 illustrates timing diagrams corresponding to a second schematic diagram of a first superimposing circuit and a second schematic diagram of a separation circuit according to an embodiment of the present disclosure.

### [Reference numerals]

1: first superimposing circuit;
11: first inverter;
12: switch;
13: oscillating circuit;
14: first operational amplifier;
15: third operational amplifier;
2: trimming chip;
3: separation circuit;
31: first comparator;
32: second inverter;
33: second operational amplifier;
34: second comparator;
4: control circuit;
5: power input pin;
6: in-chip trimming circuit;
7: state detection circuit;
8: second superimposing circuit;
9: logic control circuit.

### DESCRIPTION OF EMBODIMENTS

The technical solutions in the embodiments of the present disclosure may be clearly and completely described below in conjunction with the drawings for the embodiments of the present disclosure.

In the present disclosure, MN is an N-type Metal-Oxide-Semiconductor (MOS) transistor and MP is a P-type MOS transistor.

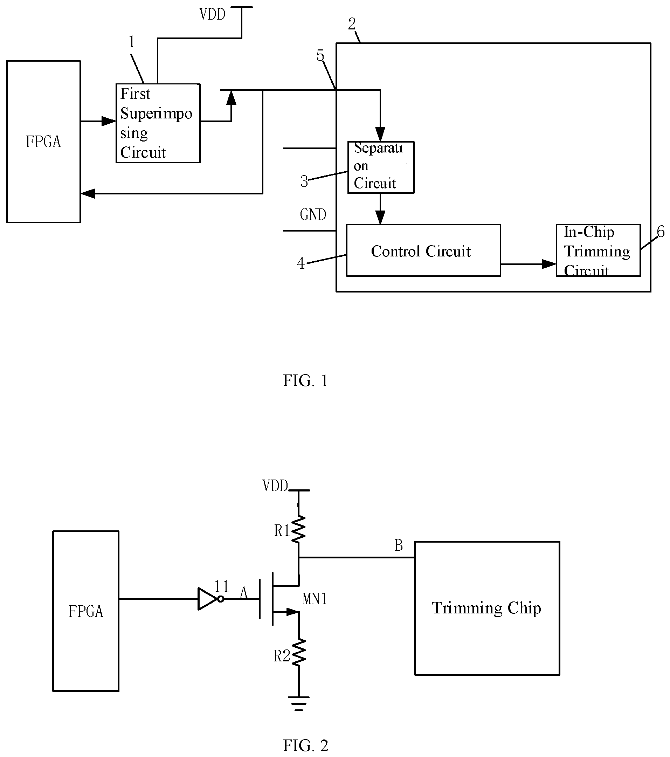

FIG. 1 illustrates a schematic diagram of a pin-multiplexed trimming circuit, which includes a first superimposing circuit 1 and a trimming chip 2, wherein the trimming chip 2 includes a separation circuit 3, a control circuit 4 and an in-chip trimming circuit 6, and the first superimposing circuit 1 is electrically connected to the separation circuit 3 through a power input pin 5 of the trimming chip 2;
the first superimposing circuit 1 is configured to receive a power supply signal and a first data signal sent by a controller, and superimpose the power supply signal with the first data signal to obtain a first fused signal;
in the embodiment herein, the controller may be a Field Programmable Gate Array (FPGA), a Digital Signal Processor (DSP), a Microcontroller Unit (MCU), or the like, and in the present disclosure, an FPGA is used as the exemplary controller;
the separation circuit 3 is configured to separate the first fused signal to obtain a second data signal and the power supply signal; the power supply signal is configured to supply power to the separation circuit 3, the control circuit 4 and the in-chip trimming circuit 6; and
the control circuit 4 is configured to decode the second data signal to obtain a third data signal, and send the third data signal to the in-chip trimming circuit 6 in the trimming chip 2.

By adopting the above technical solution, the first fused signal may be obtained by superimposing the power supply signal with the first data signal by the first superimposing circuit 1, and the first fused signal is then sent to the interior of the trimming chip 2 through the power input pin 5 of the trimming chip 2, so that the separation circuit 3 in the trimming chip 2 separates the first fused signal to obtain the second data signal. The control circuit 4 in the trimming chip 2 receives the second data signal and recovers a clock and the data according to an agreed protocol to obtain the third data signal, and then controls the in-chip trimming circuit 6 to perform trimming through the third data signal according to an agreed command format.

For the in-chip trimming circuit 6, a fuse trimming circuit is adopted in the embodiment of the present disclosure. Those skilled in the art should appreciate that depending on the number of repeatable trimming times, there may be various trimming modes such as Multiple-Time Programmable (MTP, which allows programing for multiple times), Few-Time Programmable (FTP, which allows a limited number of programmable times), and One-Time Programmable (OTP, which allows programming only once, and the data remains valid permanently once being programmed). The conventional trimming technologies include: Digital Calibration, Trimming with Register Settings, Fuse Programming or Laser Trimming, Adaptive Calibration, Multiplexer and Resistor Array, Iterative Learning Algorithm, On-Chip Self-Calibration (OSCAL), and Multistage Calibration. In the present disclosure, examples are given mainly based on fuse trimming, which itself is a specific implementation example of OTP trimming. The specific in-chip trimming circuit also takes the fuse trimming circuit as an example.

In the present disclosure, the first superimposing circuit 1 is disposed outside the trimming chip 2. Due to the large number of the chips to be trimmed during chip production, the first superimposing circuit 1 may be produced in a number different from that of the trimming chips 2, and the trimming cost can be reduced in this way. For example, when the number of the trimming chips 2 is ten, the number of the first superimposing circuit(s) 1 may be one, two or three, which is not limited herein.

In the present disclosure, the first data signal is divided into read data and write data. Firstly, the write-data process is introduced. The first data signal is in the form of a data frame, and the specific format may be 0111xxxxxyyyyyyyyz, where x represents a 5-bit address, y represents 8-bit data, and z is a checksum; 0111 is a specific flag bit, and in the present disclosure, when the flag bit is 0111, it is classified as a first type flag bit, which is corresponding to write data; and when the flag bit is 0110, it is classified as a second type of flag bit, which is corresponding to read data.

In the present disclosure, the power supply signal may be 3.3V, 5V, 12V, or the like, which is not limited herein.

In the present disclosure, the first superimposing circuit 1 may superimpose the power supply signal with the first data signal. For example, in the present disclosure, when the first data signal is at a high level, the corresponding level is 3.3V, and when the first data signal is at a low level, the corresponding level is 0V. When the power supply signal is 5V, the first superimposing circuit 1 superimposes the first data signal at a high level with the power supply signal to obtain the first fused signal of 8.3V; and the first superimposing circuit 1 superimposes the first data signal at a low level with the power supply signal to obtain the first fused signal of 5.0V. Of course, those skilled in the art may adjust the amplitudes of the first data signal and the power supply signal as needed, which is not limited herein.

In the present disclosure, the separation circuit 3 is connected to the first superimposing circuit 1 through the power input pin 5 of the trimming chip 2. In this way, the data pin of the trimming chip 2 is prevented from receiving the first data signal sent by the controller, so that a functional circuit in the trimming chip 2 can be protected from being affected, and the stability of the trimming chip 2 can be improved. In the present disclosure, the functional circuit mainly performs the core function of the trimming chip 2. For example, when the trimming chip 2 is a comparison chip, the functional circuit is a circuit that performs a comparison function; and when the trimming chip 2 is an isolated operational amplifier chip, the functional circuit is a circuit that performs an isolation amplification function. In addition, the separation circuit 3 may separate the first fused signal inside the trimming chip 2 to obtain the second data signal and the power supply signal, wherein the power supply signal may supply power to all non-functional circuits in the trimming chip 2, and the content of the second data signal is the same as that of the first data signal, and both describe 8-bit data.

In the present disclosure, the control circuit 4 is mainly configured to decode the second data signal sent by the separation circuit 3 to obtain the third data signal. Specifically, the control circuit 4 receives a pulse of a write-data frame, recovers a clock and the second data signal according to an agreed protocol, and then performs fuse trimming according to an agreed command format.

A control fuse of the control circuit 4 includes four states, such as a start fuse, a sel fuse and a stop fuse. The start fuse in the control circuit 4 indicates that trimming has started, the sel fuse determines whether the read-back data reflects the fuse-trimming result, and the stop fuse indicates that trimming has finished and the trimming function is disabled.

In the present disclosure, the in-chip trimming circuit 6 mainly performs trimming and state reading.

FIG. 2 illustrates a first schematic diagram of a first superimposing circuit 1, which includes a first inverter 11, an MN1, a resistor R1 and a resistor R2;
an input end of the first inverter 11 receives the first data signal sent by the FPGA, and an output end of the first inverter 11 is connected to a gate of the MN1;
a source of the MN1 is grounded through the resistor R2; and
a drain of the MN1 receives the power supply signal through the resistor R1, and the drain of the MN1 is connected to the power input pin 5.

The first data signal generated by the FPGA acts on the gate of the MN1 through the first inverter 11, the source of the MN1 is grounded through the resistor R2, and the drain of the MN1 is connected to the power supply signal VDD through the resistor R1. A voltage value output by the power supply signal VDD is V1; when the data output by the FPGA is 1, the MN1 is off, and an input voltage of the power input pin 5 is V1; when the data output by the FPGA is 0, the MN1 is on, and the input voltage of the power input pin 5 is V2, where V2=V1*R2/(R1+R2), and an amplitude difference between V1 and V2 is x (x may be 1V). Therefore, the first data signal is superimposed with the power supply signal to obtain the first fused signal.

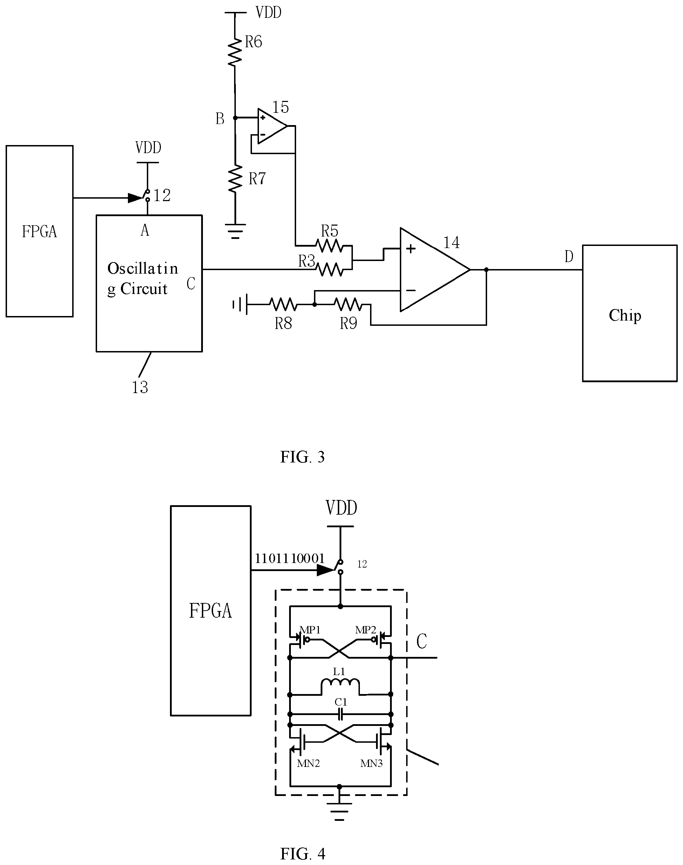

FIG. 3 illustrates a second schematic diagram of a first superimposing circuit 1, which includes a switch 12, an oscillating circuit 13, a resistor R3, a resistor R5, a resistor R6, a resistor R7, a resistor R8, a resistor R9, a first operational amplifier 14 and a third operational amplifier 15;
the oscillating circuit 13 receives the power supply signal through the switch 12, and the switch 12 receives the first data signal to be turned on or off; the oscillating circuit 13 is configured to output an oscillating signal when the switch 12 is turned on;
the oscillating signal is sent to a non-inverting input end of the first operational amplifier 14 through the resistor R3;
the resistor R6 and the resistor R7 are connected in series, and the power supply signal is grounded through the resistor R6 and the resistor R7;
the non-inverting input end of the third operational amplifier 15 is disposed at a junction of the resistor R6 and the resistor R7, an inverting input end of the third operational amplifier 15 is connected to an output end of the third operational amplifier 15, and the resistor R5 is connected in series between the output end of the third operational amplifier 15 and the non-inverting input end of the first operational amplifier 14;
an output end of the first operational amplifier 14 is grounded through the resistor R8 and the resistor R9, and a junction of the resistor R8 and the resistor R9 is connected to an inverting input end of the first operational amplifier 14; and
the output end of the first operational amplifier 14 is connected to the power input pin 5.

Two solutions of the oscillating circuit 13 are provided in the present disclosure. The first data signal generated by the FPGA acts on the oscillating circuit 13 through the switch 12, and when the first data signal output by the FPGA is at a low level (the data is 0), the switch 12 is off, the oscillating circuit 13 does not work, and a voltage at point C is 0. A voltage value output by the power supply signal VDD is V3, and a voltage at point B is V4=V3*R7/(R6+R7).

When the first data signal output by the FPGA is at a high level (the data is 1), the switch 12 is closed, the oscillating circuit 13 works, point C is at an oscillating voltage of V5, and the voltages at points C and B are superimposed by the first operational amplifier 14. The resistance values of R3, R5, R8 and R9 are reasonably set, such as R3=R5=R8=R9, so that the voltages at points C and B are superimposed by the first operational amplifier 14 to obtain an oscillating voltage V6=V4+V5, and an input voltage of the power input pin 5 is V6. Therefore, the first data signal is superimposed with the power supply signal.

FIG. 4 illustrates a first schematic diagram of an oscillating circuit 13, which includes an MP1, an MP2, an MN2, an MN3, an inductor L1 and a capacitor C1;
sources of the MP1 and the MP2 both receive the power supply signal through the switch 12;
a gate of the MP1 is connected to a drain of the MP2, and a drain of the MP1 is connected to a gate of the MP2;
two ends of the inductor L1 are electrically connected to the drain of the MP1 and the drain of the MP2, respectively;
two ends of the capacitor C1 are electrically connected to the two ends of the inductor L1, respectively;
a drain of the MN2 and a drain of the MN3 are electrically connected to the two ends of the capacitor C1, respectively;
sources of the MN2 and the MN3 are grounded;
a gate of the MN2 is connected to the drain of the MN3, and a gate of the MN3 is connected to the drain of the MN2;
the drain (i.e., point C) of the MP2 outputs the oscillating signal to the resistor R3.

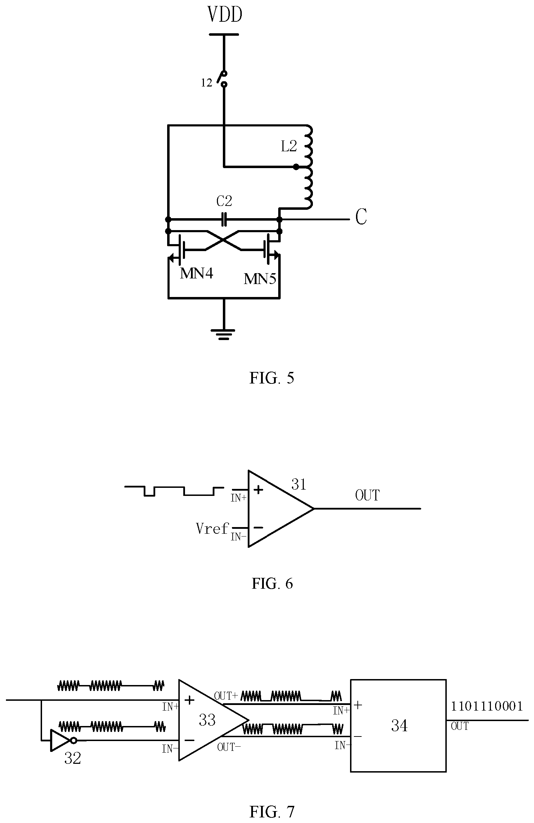

FIG. 5 illustrates a second schematic diagram of an oscillating circuit 13, which includes an MN4, an MN5, a capacitor C2 and an inductor L2;
two ends of the capacitor C2 are electrically connected to two ends of the inductor L2, respectively;
a center tap of the inductor L2 receives the power supply signal through the switch 12;
a drain of the MN4 and a drain of the MN5 are connected to two ends of the capacitor C2, respectively;
a source of the MN4 and a source of the MN5 are both grounded;
a gate of the MN4 is connected to the drain of the MN5 (i.e. point C), and a gate of the MN5 is connected to the drain of the MN4;
the drain of the MN5 outputs the oscillating signal to the resistor R3.

FIG. 6 illustrates a first schematic diagram of a separation circuit 3, which includes a first comparator 31;
a non-inverting input end IN+ of the first comparator 31 receives the first fused signal, and an inverting input end IN- thereof receives a reference voltage; and
the first comparator 31 compares the first fused signal with the reference voltage; when the first fused signal is greater than the reference voltage, an output end OUT of the first comparator 31 outputs the second data signal at a high level; and when the first fused signal is less than the reference voltage, the output end OUT of the first comparator 31 outputs the second data signal at a low level.

The first fused signal received by the power input pin 5 is connected to the non-inverting input end IN+ of the first comparator 31, and the inverting input end IN- of the first comparator 31 is connected to a reference voltage Vref, where Vref=V2+x/2; when the amplitude of the received first fused signal is greater than Vref, the first comparator 31 outputs "1"; and when the amplitude of the received first fused signal is less than Vref, the first comparator 31 outputs "0". Therefore, the first comparator 31 separates the first data signal from the received first fused signal, and the output end of the first comparator 31 outputs the second data signal.

Further, it should be understood that the power supply signal can be obtained after the first fused signal is shaped and filtered.

FIG. 7 illustrates a second schematic diagram of a separation circuit 3, which includes a second inverter 32, a second operational amplifier 33 and a second comparator 34;
a non-inverting input end IN+ of the second operational amplifier 33 receives the first fused signal;
an input end of the second inverter 32 receives the first fused signal, and an output end of the second inverter 32 is connected to an inverting input end IN- of the second operational amplifier 33; after being amplified by the second operational amplifier, are output through a non-inverting output end OUT+ and an inverting output end OUT- of the second operational amplifier, respectively.

The non-inverting output end OUT+ of the second operational amplifier 33 is connected to the non-inverting input end IN+ of the second comparator 34, the inverting output end OUT- of the second operational amplifier 33 is connected to the inverting input end IN- of the second comparator 34, and the output end OUT of the second comparator 34 outputs the second data signal at a different level.

The first fused signal received by the power input pin 5 is connected to the non-inverting input end IN+ of the second operational amplifier 33, and the first fused signal received by the power input pin 5 is inverted by the second inverter 32 and connected to the inverting input end IN- of the second operational amplifier 33. A low-frequency gain of the second operational amplifier 33 is 0, so that only the oscillating voltage is amplified after the signal passes through the second operational amplifier 33. The amplified oscillating voltage is output as "1" through the output end OUT of the second comparator 34, and a DC voltage is output as "0" through the output end OUT of the second comparator 34. Therefore, the first data signal is separated from the received first fused signal to obtain the second data signal.

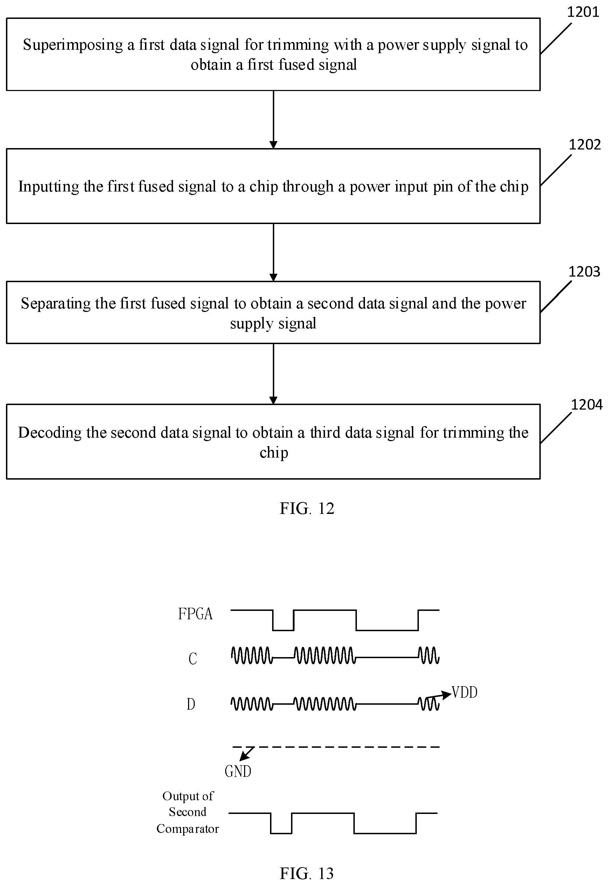

FIG. 13 illustrates timing diagrams corresponding to a second schematic diagram of a first superimposing circuit and a second schematic diagram of a separation circuit, in which signal C is a signal at point C in FIG. 3, i.e., an output signal of an oscillator, signal D is the first fused signal, and a "second comparator output" in FIG. 13 represents the second data signal, i.e., the second data signal finally obtained by the separation circuit 3.

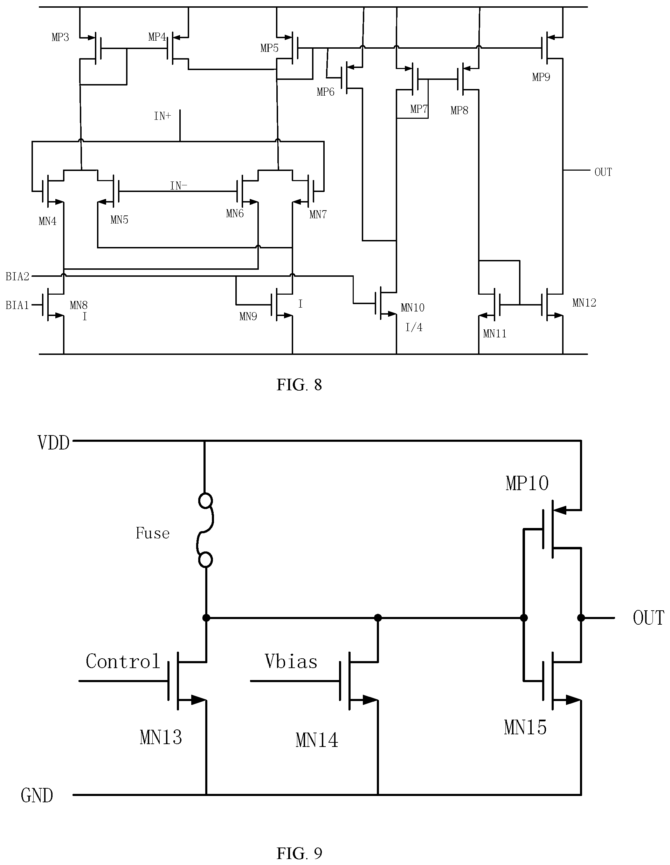

FIG. 8 illustrates a schematic diagram of a second comparator 34, which includes an MP3, an MP4, an MP5, an MP6, an MP7, an MP8, an MP9, an MN4, an MN5, an MN6, an MN7, an MN8, an MN9, an MN10, an MN11 and an MN12
wherein width to length ratios (w/l) of respective MOS tubes are as follows:
MP3:MP4:MP5:MP6:MP7:MP8:MP9=4:1:1:1:2:2:2; and
MN4:MN5:MN6:MN7:MN8:MN9:MN10:MN11:MN12=24:24:4:4:4:4: 1:1:4.

Sources of the MP3, the MP4, the MP5, the MP6, the MP7, the MP8 and the MP9 all receive the power supply signal;
a gate of the MP3 is short-circuited with a drain thereof, and the gate of the MP3 is connected to a gate of the MP4;
a drain of the MP4 is connected to a drain of the MP5, a gate of the MP5 is short-circuited with a drain thereof, and the gate of the MP5 is connected to a gate of the MP6 and a gate of the MP9;
a drain of the MP7 and a gate of the MP7 are connected to a gate of the MP8, respectively;
a drain of the MP3 is connected to a drain of the MN4 and a drain of the MN5 respectively, and a drain of the MP5 is connected to a drain of the MN6 and a drain of the MN7, respectively;
the drain of the MP6 and the drain of the MP7 are connected to a drain of the MN10, respectively, a drain of the MP8 is connected to a drain of the MN11, and a drain of the MP9 is connected to a drain of the MN12;
a gate of the MN4 and a gate of the MN7 are both connected to a non-inverting input end of the second comparator, and a gate of the MN5 and a gate of the MN6 are both connected to an inverting input end of the second comparator;
a source of the MN4 and a source of the MN6 are both connected to a drain of the MN8, and a gate of the MN8 receives a first bias voltage BIA1;
a source of the MN5 and a source of the MN7 are both connected to a drain of the MN9, and a gate of the MN9 receives a second bias voltage BIA2;
a gate of the MN10 receives the second bias voltage BIA2, and the first bias voltage BIA1 and the second bias voltage BIA2 may or may not be equal; the first bias voltage BIA1 controls current flowing through the MN8 to be I; the second bias voltage BIA2 controls current flowing through the MN9 to be I, and current flowing through the MN10 to be I/4;
a gate of the MN11 is connected to a gate of the MN12, and the gate of the MN11 is connected to a drain thereof; and
the drain of the MP9 outputs the second data signal.

When the first fused signal includes an oscillating voltage, either the MN4 and the MN7, or the MN5 and the MN6, are turned off, and all the current flows through the remaining NMOS tubes. At this time, drain current of the MP3 is I, drain current of the MN8 is I, drain current of the MN9 is I, and drain current of the MN10 is I/4. Since MP3:MP4=4:1, drain current of the MP4 is I/4, and drain current of the MP5 is 3I/4; and since MP5:MP6=1:1, drain current of the MP6 is 3I/4. Since 3I/4 is greater than I/4, the current flowing through MP7, MP8, MN11 and the MN12 is 0, the MP9 is turned on, and "1" is output. When the received first fused signal is of a DC voltage, the MN4, the MN7, the MN5 and the MN6 are all turned on. At this time, drain current of the MP3 is 6*I/7, and the sum of the drain currents flowing through the MP4 and the MP5 is I/7. Since MP3:MP4 = 4:1, the drain current flowing through the MP4 is 3*I/14, and since 3I/14 is greater than I/7, the MP5 and the MP9 are turned off, and "0" is output.

FIG. 9 illustrates a schematic diagram of a trimming unit in a fuse trimming circuit, wherein the trimming unit includes an MN13, an MN14, an MN15 and an MP10.

It should be understood that the in-chip trimming circuit 6 may be specifically the fuse trimming circuit, and includes N (N≥1) trimming units as illustrated in FIG. 9.

Sources of the MN 13, the MN 14 and the MN15 are all grounded;
a gate of the MN13 receives the third data signal Control sent by the control circuit 4, and a drain of the MN13 receives the power supply signal through a fuse resistor;
a gate of the MN14 receives a bias voltage signal Vbias, and a drain of the MN14 is connected to the drain of the MN13;
gates of the MN15 and the MP10 are both connected to the drain of the MN14, and a source of the MP10 receives the power supply signal;
a drain of the MN15 is connected to the drain of the MP10, and a drain of the MN15 outputs the read-back data.

The bias voltage signal Vbias controls the MN14 to provide a weak pull-down current, i.e., the MN14 is turned on, but when only the MN14 is turned on, the current through the fuse is not sufficient to blow the fuse, and for example, the pull-down current may be 1µA. When the third data signal received by the gate Control of the MN13 is 0 (low level), the MN13 is turned off, the fuse is not blown, the gates of the MN15 and the MP10 are connected to the VDD through the fuse, the MN15 is turned on, the MP10 is turned off, and the OUT outputs a low level; when the third data signal received by the gate Control of the MN13 is 1 (high level), the MN13 is turned on and the fuse is blown; after the fuse is blown, the weak pull-down current provided by the MN14 causes the gates of the MN15 and the MP10 to be at a low level, thus ensuring that the output from the OUT is stable at a high level.

On the other hand, in some cases, it is necessary to read back a fuse state of the trimming chip 2, so the present disclosure further designs related circuits for reading back data, and the details are as follows.

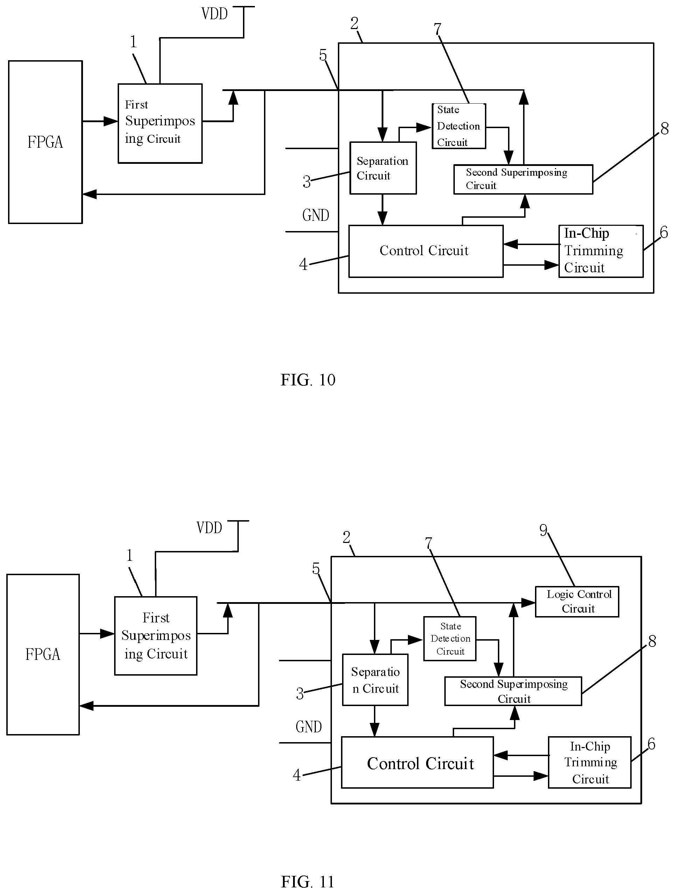

FIG. 10 illustrates a schematic diagram of a trimming circuit with a second superimposing circuit, wherein the trimming circuit further includes a state detection circuit 7 and a second superimposing circuit 8; and the state detection circuit 7 is electrically connected to the separation circuit 3 and the second superimposing circuit 8, respectively;
the state detection circuit 7 is configured to detect a flag bit of the second data signal, disable the second superimposing circuit 8 when the flag bit is a first type of flag bit, i.e., in a write-data state, and enable the second superimposing circuit 8 when the flag bit is a second type of flag bit, i.e., in a read-data state; and
the second superimposing circuit 8 is configured to receive read-back data of the in-chip trimming circuit 6, superimpose the read-back data with the power supply signal to obtain a second fused signal, and send the second fused signal to the controller through the power input pin 5.

In the present disclosure, the second superimposing circuit 8 is disposed inside the trimming chip 2, and the circuit structure of the second superimposing circuit 8 is the same as that of the first superimposing circuit 1. For example, the second superimposing circuit 8 includes a first inverter 11, an MN1, a resistor R1 and a resistor R2; an input end of the first inverter 11 receives the read-back data, and an output end of the first inverter 11 is connected to a gate of the MN1; a source of the MN1 is grounded through the resistor R2; and a drain of the MN1 receives the power supply signal through the resistor R1, and the drain of the MN1 is connected to the power input pin. Those skilled in the art can adopt the circuit principle of the first superimposing circuit 1 to build the second superimposing circuit 8 as needed. In the present disclosure, the format of the read-back data is 0110xxxxx00000000z00000000, where x represents a 5-bit address and z represents a checksum. In this way, the state of a specific fuse in the in-chip trimming circuit 6 can be read using a specific address.

FIG. 11 illustrates a schematic diagram of a trimming circuit which further includes a logic control circuit 9;
the logic control circuit 9 is configured to adjust the state of the trimming chip 2 according to the first/second fused signal; when the first fused signal includes the first data signal (or the second fused signal includes the read-back data signal), the separation circuit 3, the second superimposing circuit 8, the state detection circuit 7, the control circuit 4 and the in-chip trimming circuit 6 are enabled, and the functional circuit in the trimming chip 2 is disabled; and
when the first fused signal does not include the first data signal (or the second fused signal does not include the read-back data signal), the functional circuit in the trimming chip 2 is enabled, and all circuits related to a trimming action are disabled, such as the separation circuit 3, the second superimposing circuit 8, the state detection circuit 7, the control circuit 4 and the in-chip trimming circuit 6.

Through the logic control circuit 9, it may be ensured that the trimming circuit may not be affected by the functional circuit during trimming, and when the functional circuit works, all circuits related to the trimming action may be disabled to prevent all circuits related to the trimming action from affecting the functional circuit.

Based on the same inventive concept, an embodiment of the present disclosure further provides a trimming chip, which includes a power input pin, a separation circuit, a control circuit and an in-chip trimming circuit, wherein the power input pin is electrically connected to the separation circuit, the control circuit is electrically connected to the separation circuit, and the in-chip trimming circuit is electrically connected to the control circuit;
the power input pin is configured to receive a first fused signal, which may be formed by superimposing a power supply signal and a first data signal for trimming by the first superimposing circuit illustrated in FIG. 2 or 3;
the separation circuit is configured to separate the first fused signal to obtain the power supply signal and a second data signal; the power supply signal is configured to supply power to the in-chip trimming circuit, the separation circuit and the control circuit;
the control circuit is configured to decode the second data signal to obtain a third data signal and send the third data signal to the in-chip trimming circuit.

The trimming chip further includes a state detection circuit and a second superimposing circuit; the state detection circuit is electrically connected to the separation circuit and the second superimposing circuit, respectively, and the second superimposing circuit is electrically connected to the power input pin and the control circuit, respectively;
the state detection circuit is configured to detect a flag bit of the second data signal, disable the second superimposing circuit when the flag bit is a first type of flag bit, and enable the second superimposing circuit when the flag bit is a second type of flag bit;
the second superimposing circuit is configured to receive read-back data of the in-chip trimming circuit, superimpose the read-back data with the power supply signal to obtain a second fused signal, and output the second fused signal through the power input pin.

The separation circuit may refer to FIGS. 6 and 7, the second superimposing circuit may refer to FIGS. 2 and 3, and the second comparator may refer to FIG. 8. Since the trimming chip of the embodiment has the same principle as the pin-multiplexed trimming circuit described above, the repeated content is omitted.

For the design of analog integrated circuits such as a high-precision reference, an operational amplifier, and an analog-to-digital (AD) converter, the precision requirements for the circuit parameters are extremely high. Therefore, trimming is generally performed on a chip after package, and it is necessary to read back a trimming result. The common practice is to use a data pin in the chip to write and read the data of fuse trimming. However, the use of the data pin for the fuse trimming causes the data pin to be connected to both a functional circuit and a trimming circuit in the trimming chip simultaneously, which easily leads to the instability of the chip in use.

In order to solve the above problem, based on the same inventive concept, an embodiment of the present disclosure provides a chip trimming method, which can avoid the use of the data pin of the trimming chip 2 to realize fuse trimming. FIG. 12 illustrates a schematic diagram of steps of a chip trimming method according to an embodiment of the present disclosure. The specification provides the operation steps of the methods as illustrated in the embodiments or flowcharts, but more or less operation steps may be included based on routine or non-creative labor. The sequence of steps listed in the embodiments is only one of various execution sequences of steps, and does not mean a unique execution sequence. When being executed in an actual system or device product, the steps may be executed sequentially or concurrently according to the method illustrated in the embodiments or the drawings. Specifically, as illustrated in FIG. 12, the method may include:
Step 1201: superimposing a first data signal for trimming with a power supply signal to obtain a first fused signal;
Step 1202: inputting the first fused signal to a chip through a power input pin of the chip;
Step 1203: separating the first fused signal to obtain a second data signal and the power supply signal; and
Step 1204: decoding the second data signal to obtain a third data signal for trimming the chip.

As an embodiment of the present disclosure, the method further includes:
superimposing read-back data signal, which indicates a trimming unit of the chip, with the power supply signal to obtain a second fused signal; and
outputting the second fused signal to the outside of the chip through the power input pin of the chip.

It should be understood that in various embodiments of the present disclosure, the sequence number of each process described above does not mean an order of execution, and the order of execution of each process should be determined according to its function and inherent logic, and should not constitute any limitation to the implementation process of the embodiments of the present disclosure.

## Claims

1. A pin-multiplexed trimming circuit, comprising: a first superimposing circuit and a trimming chip, wherein the trimming chip comprises a separation circuit, a control circuit and an in-chip trimming circuit, and the first superimposing circuit is electrically connected to the separation circuit through a power input pin of the trimming chip;
the first superimposing circuit is configured to receive a power supply signal and a first data signal sent by a controller, and superimpose the power supply signal with the first data signal to obtain a first fused signal;
the separation circuit is configured to separate the first fused signal to obtain a second data signal and the power supply signal; the power supply signal is configured to supply power to the in-chip trimming circuit, the separation circuit, and the control circuit; and
the control circuit is configured to decode the second data signal to obtain a third data signal, and send the third data signal to the in-chip trimming circuit in the trimming chip.

2. The pin-multiplexed trimming circuit according to claim 1, further comprising a state detection circuit and a second superimposing circuit; the state detection circuit is electrically connected to the separation circuit and the second superimposing circuit, respectively;
the state detection circuit is configured to detect a flag bit of the second data signal, disable the second superimposing circuit when the flag bit is a first type of flag bit, and enable the second superimposing circuit when the flag bit is a second type of flag bit;
the second superimposing circuit is configured to receive read-back data of the in-chip trimming circuit, superimpose the read-back data with the power supply signal to obtain a second fused signal, and send the second fused signal to the controller through the power input pin.

3. The pin-multiplexed trimming circuit according to claim 1 or 2, wherein the first superimposing circuit comprises a first inverter, an MN1, a resistor R1 and a resistor R2;
an input end of the first inverter receives the first data signal sent by the controller, and an output end of the first inverter is connected to a gate of the MN1;
a source of the MN1 is grounded through the resistor R2; and
a drain of the MN1 receives the power supply signal through the resistor R1, and the drain of the MN1 is connected to the power input pin.

4. The pin-multiplexed trimming circuit according to claim 1 or 2, wherein the first superimposing circuit comprises a switch, an oscillating circuit, a resistor R3, a resistor R5, a resistor R6, a resistor R7, a resistor R8, a resistor R9, a first operational amplifier and a third operational amplifier;
the oscillating circuit receives the power supply signal through the switch, and the switch receives the first data signal to be turned on or off; the oscillating circuit is configured to output an oscillating signal when the switch is turned on;
the oscillating signal is sent to a non-inverting input end of the first operational amplifier through the resistor R3;
the resistor R6 and the resistor R7 are connected in series, and the power supply signal is grounded through the resistor R6 and the resistor R7;
a non-inverting input end of the third operational amplifier is disposed at a junction of the resistor R6 and the resistor R7, an inverting input end of the third operational amplifier is connected to an output end of the third operational amplifier, and the resistor R5 is connected in series between the output end of the third operational amplifier and the non-inverting input end of the first operational amplifier;
an output end of the first operational amplifier is grounded through the resistor R8 and the resistor R9, and a junction of the resistor R8 and the resistor R9 is connected to an inverting input end of the first operational amplifier; and
the output end of the first operational amplifier is connected to the power input pin.

5. The pin-multiplexed trimming circuit according to claim 1 or 2, wherein the separation circuit comprises a first comparator;
a non-inverting input end of the first comparator receives the first fused signal, and an inverting input end of the first comparator receives a reference voltage; and
the first comparator compares the first fused signal with the reference voltage; when the first fused signal is greater than the reference voltage, an output end of the first comparator outputs the second data signal at a high level; and when the first fused signal is less than the reference voltage, the output end of the first comparator outputs the second data signal at a low level.

6. The pin-multiplexed trimming circuit according to claim 1 or 2, wherein the separation circuit comprises a second inverter, a second operational amplifier and a second comparator;
a non-inverting input end of the second operational amplifier receives the first fused signal;
an input end of the second inverter receives the first fused signal, and an output end of the second inverter is connected to an inverting input end of the second operational amplifier; and
output ends of the second operational amplifier are connected to input ends of the second comparator, and an output end of the second comparator outputs the second data signal at a different level.

7. A trimming chip, comprising: a power input pin, a separation circuit, a control circuit and an in-chip trimming circuit, wherein the power input pin is electrically connected to the separation circuit, and the control circuit is electrically connected to the separation circuit, and the in-chip trimming circuit is electrically connected to the control circuit;
the power input pin is configured to receive a first fused signal, which is formed by superimposing a power supply signal and a first data signal for trimming;
the separation circuit is configured to separate the first fused signal to obtain the power supply signal and a second data signal; the power supply signal is configured to supply power to the in-chip trimming circuit, the separation circuit and the control circuit; and
the control circuit is configured to decode the second data signal to obtain a third data signal and send the third data signal to the in-chip trimming circuit.

8. The trimming chip according to claim 7, wherein the trimming chip further comprises a state detection circuit and a second superimposing circuit; the state detection circuit is electrically connected to the separation circuit and the second superimposing circuit, respectively, and the second superimposing circuit is electrically connected to the power input pin and the control circuit, respectively;
the state detection circuit is configured to detect a flag bit of the second data signal, disable the second superimposing circuit when the flag bit is a first type of flag bit, and enable the second superimposing circuit when the flag bit is a second type of flag bit; and
the second superimposing circuit is configured to receive read-back data of the in-chip trimming circuit, superimpose the read-back data with the power supply signal to obtain a second fused signal, and output the second fused signal through the power input pin.

9. The trimming chip according to claim 7 or 8, wherein the in-chip trimming circuit is a fuse trimming circuit.

10. The trimming chip according to claim 8, wherein the second superimposing circuit comprises a first inverter, an MN1, a resistor R1 and a resistor R2;
an input end of the first inverter receives the read-back data, and an output end of the first inverter is connected to a gate of the MN1;
a source of the MN1 is grounded through the resistor R2; and
a drain of the MN1 receives the power supply signal through the resistor R1, and the drain of the MN1 is connected to the power input pin.

11. The trimming chip according to claim 7 or 8, wherein the separation circuit comprises a first comparator;
a non-inverting input end of the first comparator is electrically connected to the power input pin and configured to receive the first fused signal, an inverting input end of the first comparator is configured to receive a reference voltage, and an output end of the first comparator is electrically connected to the control circuit;
the first comparator compares the first fused signal with the reference voltage; when the first fused signal is greater than the reference voltage, the output end of the first comparator outputs the second data signal at a high level; and when the first fused signal is less than the reference voltage, the output end of the first comparator outputs the second data signal at a low level.

12. The trimming chip according to claim 7 or 8, wherein the separation circuit comprises a second inverter, a second operational amplifier and a second comparator;
a non-inverting input end of the second operational amplifier is electrically connected to the power input pin and configured to receive the first fused signal;
an input end of the second inverter is electrically connected to the power input pin and configured to receive the first fused signal, and an output end of the second inverter is connected to an inverting input end of the second operational amplifier;
output ends of the second operational amplifier are connected to input ends of the second comparator; and
an output end of the second comparator is electrically connected to the control circuit and configured to output the second data signals at a different level.

13. The trimming chip according to claim 12, wherein the second comparator comprises an MP3, an MP4, an MP5, an MP6, an MP7, an MP8, an MP9, an MN4, an MN5, an MN6, an MN7, an MN8, an MN9, an MN10, an MN11 and an MN12;
sources of the MP3, the MP4, the MP5, the MP6, the MP7, the MP8 and the MP9 all receive the power supply signal;
sources of the MN8, the MN9, the MN10, the MN11 and the MN12 are all grounded;
a gate of the MP3 is short-circuited with a drain thereof, and the gate of the MP3 is connected to a gate of the MP4;
a drain of the MP4 is connected to a drain of the MP5, a gate of the MP5 is short-circuited with a drain thereof, and the gate of the MP5 is connected to a gate of the MP6 and a gate of the MP9;
a drain of the MP7 and a gate of the MP7 are connected to a gate of the MP8, respectively;
a drain of the MP3 is connected to a drain of the MN4 and a drain of the MN5, respectively, and the drain of the MP5 is connected to a drain of the MN6 and a drain of the MN7, respectively;
the drain of the MP6 and the drain of the MP7 are connected to a drain of the MN10, respectively, a drain of the MP8 is connected to a drain of the MN11, and a drain of the MP9 is connected to a drain of the MN12;
a gate of the MN4 and a gate of the MN7 are both connected to a non-inverting input end of the second comparator, and a gate of the MN5 and a gate of the MN6 are both connected to an inverting input end of the second comparator;
a source of the MN4 and a source of the MN6 are both connected to a drain of the MN8, and a gate of the MN8 receives a first bias voltage BIA1;
a source of the MN5 and a source of the MN7 are both connected to a drain of the MN9, and a gate of the MN9 receives a second bias voltage BIA2;
a gate of the MN10 receives the second bias voltage BIA2;
a gate of the MN11 is connected to a gate of the MN12, and the gate of the MN11 is connected to a drain thereof; and
the drain of the MP9 outputs the second data signal.

14. The trimming chip according to claim 7, further comprising a logic control circuit;
the logic control circuit is configured to adjust the state of the trimming chip according to the first fused signal; when the first fused signal comprises the first data signal, the logic control circuit is configured to enable the separation circuit, the control circuit and the in-chip trimming circuit; and
when the first fused signal does not comprise the first data signal, the logic control circuit is configured to enable a functional circuit in the trimming chip.

15. The trimming chip according to claim 8, further comprising a logic control circuit;
the logic control circuit is configured to adjust the state of the trimming chip according to the first fused signal; when the first fused signal comprises the first data signal, the logic control circuit is configured to enable the separation circuit, the second superimposing circuit, the state detection circuit, the control circuit and the in-chip trimming circuit; and
when the first fused signal does not comprise the first data signal, the logic control circuit is configured to enable a functional circuit in the trimming chip.

16. A chip trimming method, comprising:
superimposing a first data signal for trimming with a power supply signal to obtain a first fused signal;
inputting the first fused signal to a chip through a power input pin of the chip;
separating the first fused signal to obtain a second data signal and the power supply signal; and
decoding the second data signal to obtain a third data signal for trimming the chip.

17. The chip trimming method according to claim 16, further comprising:
superimposing read-back data signal, which is configured to indicate a trimming unit of the chip, with the power supply signal to obtain a second fused signal; and
outputting the second fused signal to the outside of the chip through the power input pin of the chip.
